(19) Europäisches Patentamt European Patent Office Office européen des brevets

(11) **EP 2 221 597 A1**

(12) **EUROPEAN PATENT APPLICATION**
published in accordance with Art. 153(4) EPC

(43) Date of publication:
**25.08.2010 Bulletin 2010/34**

(51) Int Cl.:
*G01M 13/04* (2006.01)      *G01R 15/18* (2006.01)
*G01M 15/00* (2006.01)

(21) Application number: **08850035.0**

(22) Date of filing: **14.11.2008**

(86) International application number:
**PCT/ES2008/000719**

(87) International publication number:
**WO 2009/063118 (22.05.2009 Gazette 2009/21)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **14.11.2007  ES 200703069**
**04.07.2008  ES 200802045**
**04.07.2008  ES 200802051**

(71) Applicant: **Universitat Politècnica de Catalunya**
**08034 Barcelona (ES)**

(72) Inventors:
• **CUSIDÓ I ROURA, Jordi**
  **08034 Barcelona (ES)**

• **ROMERAL MARTÍNEZ, José Luis**
  **08034 Barcelona (ES)**
• **ORTEGA REDONDO, Juan Antonio**
  **08034 Barcelona (ES)**
• **GARCÍA ESPINOSA, Antonio**
  **08034 Barcelona (ES)**
• **DELGADO PRIETO, Miguel**
  **08034 Barcelona (ES)**
• **PONCELAS LÓPEZ, Oscar**
  **08034 Barcelona (ES)**

(74) Representative: **Barlocci, Anna**
**ZBM PATENTS**
**Zea, Barlocci & Markvardsen**
**Pl. Catalunya, 1**
**08002 Barcelona (ES)**

(54) **SYSTEM FOR DIAGNOSING DEFECTS IN ELECTRIC MOTORS**

(57)     The invention relates to a device for the diagnosis of flanges in tri-phase motors. More specifically, the invention relates to a device comprising means for the inductive aquisition of currents in a common mode for the simple and practical diagnosis of the defects in the flanges of a tri-phase motor. The invention also relates to a current-measuring device comprising means for capturing currents by inductive methods. The invention further relates to a device and a method for detecting defects in alternating-current electric motors, and more specifically, to a device and a method for obtaining parameters relating to the possible defects in an electric motor, in order to carry out a reliable diagnosis of the defects during the normal operation of the motor.

# FIG. 1

Common mode current collecting probe → Signal conditioning circuit → Digital processing circuit → Bearing diagnosis

EP 2 221 597 A1

**Description**

**BACKGROUND**

The electric induction motor, or also referred to as asynchronous motor, is a type of alternating current electric motor and at present is the most widely used electric machine: about 70% of the industrial applications employ induction motors, and over 50% of the energy consumed in industrialized countries is due to this type of motors.

A good preventive maintenance for detecting defects in time in a motor is of special importance in the industrial sector. For this purpose several techniques are used at present, among which the following are prominent: spectral analysis of vibrations and acoustic noise, electromagnetic field monitoring and axial flow measurement, temperature measurement, infrared recognition, and spectral analysis of current in the motor (for example, the analysis referred to as MCSA).

Particularly referring to the last technique, MCSA is the most widely used nowadays and it is based on the spectral analysis of currents in the stator of the electric motor which requires at least one current sensor to be provided for each machine. It is used for diagnosing mechanical defects in motors, such as broken bars, eccentricity, shorted turns, damaged bearings; and also electric defects, such as open phase and abnormal connections. However, although the MCSA technique works properly under fixed frequency power supply conditions, it can not be employed with motors under non stationary conditions.

In addition, for carrying out the so-called MCSA method for diagnosing defects, it is necessary to measure the current flowing through the stator of the motor. For this purpose, several options exist. Prominent methods are as follows:

- Shunt resistor
- Hall effect sensors
- Transformers

A further alternative as current measuring sensor, both for MCSA and other methods for diagnosing defects in electric motors, is the use of Rogowski coils, that consist of a toroid having a core of air or of a non magnetic material. The simplicity of the design and the lack of a magnetic core makes the cost of the Rogowski coil to be lower than that of the other types of sensors for current measurement.

For measuring current, it is placed around a conductor wire. When a variable current flows through this conductor a magnetic field is created inducing an electromotive force in the coil proportional to the derivative of the current.

For obtaining a signal proportional to the current flowing through the motor integrator circuits are used. The final output voltage of the probe depends on the core and the integrator circuit gain.

However, integrator circuits have saturation problems due to non-ideality of the parts and due to the type of currents with asymmetric overshoot flowing through motors.

Motors are usually fed by power inverter circuits, which generate voltage pulses overlapping the fundamental harmonic with a certain asymmetry, that is, the area of the positive and negative portions of the wave may be different. This results in the feedback capacitor of the integrator circuit to be charged until the circuit is saturated, especially in low-frequency measurements where it is difficult to filter this component prior to the integration process. In general, integrator circuits are difficult to adjust to avoid these problems.

On the other hand, among all of the defects occurred, specifically in three-phase induction motors, defects located in bearings are the most common, besides being the first to appear due to the continued use of the motor over long periods of time. The main causes of deterioration in bearings may be classified into a first group of causes of mechanical origin, which would include all those coming from friction between bearings and their rail, such as eccentricity, shocks on the shaft, etc., and on the other hand, a second group of causes of electrical origin.

The great majority of these latter are due to the phenomenon known as common mode current discharges. Common mode currents are generated to a great extent due to the use of variators for controlling the motors that create common mode voltages. This current flows in the motor through different ways and comes back to the variator. One of the most damaging ways through which this current flows are the motor bearings, as the parts of the bearing become physically worn by this current. This high frequency current arises as a discharge through the bearing, the rail and the lubricant, since these three elements form a capacitor effect that stores energy until exceeding the level of potential necessary to produce a current discharge. This phenomenon is known as EDM (Electric Discharge Machining). Discharges occur at high frequency and with a high repetition period, causing the wear of the bearings to be accelerated.

Currently, the most widely used mode of diagnosis for detecting defects in bearings is the use of accelerometers, which indicate that the bearings are worn by detecting vibrations in the motor. But in this case, vibration detecting systems are complex and they must be placed at certain specific points in the motor, which is impractical for being used occasionally and in addition detecting of defects is performed at a time when there is very little response time to alleviate the problem.

On the other hand, a prior art system is known for diagnosing defects in bearing as described in the patent application JP2001289738, wherein measurements of common mode current discharges through the motor bearings are performed by means of a brush placed at a point in the shaft, said brush being in direct contact with the shaft at all times.

However, although common mode current discharges through motor bearings are detected, this system requires direct contact of the brush with the shaft, and a costly installation in an inaccessible location such as a portion of the shaft near the motor, with no possibility of placing the system anywhere which is easier to install due to contact between the system and the shaft.

**Summary of the Invention**

From these known diagnosing methods, the object of the present invention is to provide a system and a method for diagnosing defects in electric motors, which is effective and unobtrusive.

According to a first aspect, the present invention relates to a device for diagnosing bearings in three-phase motors comprising at least one inductive effect probe for acquiring common mode current and current processing means, that comprise counting means for the number of discharges per unit time.

Through this device, it is possible to detect defects in a three-phase motor of any type, such as a three-phase induction motor, and perform an early diagnosis of motor wear evolution. By using an inductive effect probe it is possible to perform current acquisition and therefore subsequent diagnosis of motor bearings, in a non-invasive manner, simplifying the process without modifying the motor, and being able to perform the diagnosis during motor operation, without the need of stopping, for example, the production of a plant where the motor is installed.

In addition, the device for diagnosing of bearings of the present invention will preferably serve the purpose of detecting defects in an induction motor, but it is also possible to be used in any type of three-phase alternating current motor, such as, for example, permanent magnet motors.

According to one embodiment of the invention, the inductive effect probe comprises a ferromagnetic core, the ferromagnetic core forces of the flow of the field therethrough improving in some cases the resolution in current acquisition.

According to one alternative embodiment of the invention, the inductive effect probe is a probe of the Rogowski type.

The fact of using a Rogowski coil provides advantages over other types of transformers as it can be open and flexible due to their design, which allows a conductor wire or an electrical device such as a three-phase motor to be measured, because of its wide range of possibilities in shapes and designs. In addition, since the Rogowski coil has no iron core, but air core, it has a low inductance and response to rapidly varying currents and provides high linearity even when measuring high currents, such as three-phase motor supply currents, due to the lack of iron in the core.

According to a further embodiment of the invention, the current processing means comprise a current discharge counting circuit comprising at least one analog stage.

According to a further embodiment of the invention, the discharge counting circuit is a common mode current discharge counting circuit.

The common mode is a method of measuring current consisting in simultaneous implementation of all supplying phases with a single probe. Passing all the power wires through the same probe results in the magnetic fields due to currents to be added up. This mode of implementation is what is known as common mode.

According to one embodiment of the invention, the analog stage includes a signal preconditioning step and a comparing step.

According to a further embodiment of the present invention, the comparing step comprises at least one analog comparator.

According to a preferred embodiment, the current processing means comprise a current discharge counting circuit comprising a digital stage. Thus, counting of calculations performed by the device are faster and contain fewer inaccuracies in their intermediate stages.

According to one specific embodiment of the invention, the digital stage comprises a PLD for counting of pulses.

According to one embodiment of the invention, the digital stage is comprised within a microcontroller.

More particularly, according to one embodiment of the invention, the microcontroller is embedded within a FPGA.

According to one alternative embodiment of the invention, the digital stage is comprised in a DSP.

According to a further aspect of the invention there is provided a method for diagnosing bearings in three-phase motors comprising the steps of:

- Obtaining a signal relating to the common mode current of the motor;
- Counting the number of peaks exceeding a predetermined value of current for a predetermined period of time.

Thus, by observing the number of discharges exceeding a predetermined level of current, it is noted that a smaller number of discharges exceeding the predetermined level is indicative of a state of wear in motor bearings, and this number is therefore used for diagnosing a bearing failure condition.

The choice for the predetermined level of current to be set in order to thus count the peaks exceeding this level and to obtain the diagnosis should be done with the motor installed and in operation, and a level will be selected below the observed maximum levels of common mode discharge current for the newly installed motor, or the one considered as "healthy" at that time.

According to one preferred embodiment, in the step of performing the counting, the predetermined value of current lies in the range of 0.5 to 1.5 times the common mode current of the obtained signal.

According to another aspect of the invention there is provided a device for measuring currents comprising means for collecting current by inductive methods and conditioning electronics comprising at least one amplifier stage and at least one filter stage, said device lacking an integrator circuit.

In one preferred embodiment of the invention, the current collection means are a Rogowski probe.

Since the probe can be of different shapes and sizes, it is very versatile to collect current from, for example, the outside of a motor, or a cable installed in a not readily accessible location, since only approaching the probe to an area near the device or cable whose current is to be measured, an optimal measurement for obtaining information on such current is obtained.

One example of a Rogowski probe with optimal size for a proper collection of currents may be one that is built on a polyethylene core with 500 copper turns, an area of about 56.25 mm$^2$, and a radius of about 3.75 mm.

According to another preferred embodiment, the current collection means is a probe with a ferromagnetic core.

According to a preferred embodiment of the invention, the amplifier stage comprises a non-inverting stage and a low-pass RC filter.

According to one embodiment of the invention, the device may be used for diagnosing electrical equipment. More specifically, those methods in which it is necessary to collect currents from certain points in the equipment for e.g. analyzing the behavior of the spectrum of said collected current signal.

More specifically, according to a further embodiment, the electrical equipment are electric machines.

According to a further embodiment, the electric machines are alternating current machines.

More specifically, according to a further embodiment, the alternating current machines are induction motors. Furthermore, in the group of induction motors, they may be PMSM motors or a SRM motor.

According to a further preferred embodiment of the invention, the device is suitable for use in prognosis of electric machines, more specifically, of alternating current electric machines, such as an induction motor or motors of the PMSM type or the SRM type.

According to a further aspect of the invention there is provided a method for detecting defects in electric motors for diagnosing defects during motor operation through non invasive methods, comprising applying self-tuning filters based on of wavelet Agnesi function convolution with the supply currents of the electric motor.

According to a preferred embodiment of the invention, the process of detecting failures in alternating current electric motors comprises the steps of:

a) Obtaining the signal relating to stator currents of an electric motor;
b) Obtaining speed and sliding evolution of the electric motor;
c) Locating at least one fault frequency of the signal obtained;
d) Calculating at least one filter relating to the located fault frequency by using the wavelet Agnesi function;
e) Convoluting the signal obtained with the calculated filter;
f) Obtaining a fault factor by the integral of the squared convolution result.

By means of this method it is possible to perform a reliable preventive detection of defects in alternating current electric motors that serves for carrying out on-line diagnosis of defects (i.e. during the normal motor operation) in synchronous motors, and it serves in turn to carry out on-line and off-line diagnosis of defects in asynchronous motors.

The fault factor obtained in step g) is defined as the energy associated with each of the bands in the convolved signal. This allows the magnitude of the energy to be known in each fault frequency or range of frequencies relating to a particular defect and thereby to be able to perform a diagnosis on the relevance of this defect.

According to one specific embodiment, step b) of obtaining speed and sliding evolution is performed using the stator currents themselves.

It is possible for a motor fault to have more than one fault frequency resulting in several different frequencies to be located in step c) as classified as corresponding to the same type of fault. Consequently, the filter to be calculated in step d) will be more complex in order to be able to filter different fault frequencies corresponding to the same defect, or it may be further calculated a number of filters for each fault frequency or those comprising a part of the frequencies each one, in a way that when convolving the signal with each of them in step e) and summing up the results, the same result is obtained, but in a more optimal way.

According to a further aspect of the invention there is provided a device for detection of defects in alternating current motors, **characterized in that** it comprises means for obtaining the signal relating to stator currents in an electric motor; means for obtaining speed and sliding evolution of the electric motor; means for locating at least one fault frequency of the signal obtained; means for calculating at least one filter relating to the localized fault frequency, through the wavelet Agnesi function; means for convolving the signal obtained with tuned filter banks and means for obtaining a fault factor by the integral of the squared convolution result.

According to a preferred embodiment, the means for obtaining the signal relating to stator currents in an electric motor is a probe with an acquisition ranging from 2 to 5 kHz.

According to a preferred embodiment, the device is suitable for use in electric motors of the permanent magnet synchronous motor type.

Alternatively, according to a preferred embodiment, the device is suitable for use in electric motors of the asynchronous motor type.

As it can be seen, one possible embodiment of the invention could also be the device for diagnosing bearings in three-phase motors according to claims 1 to 14, which inductive effect probe comprises the device for measuring currents according to claim 15, or more particularly a Rogowski probe. In this way, the device for diagnosing bearings would be more resistant to possible saturations if, for example, the device for measuring currents comprises a Rogowski probe, this being much more versatile for measuring of currents in the environment where there is an electric motor. In addition, the device for measuring currents allows diagnosing of bearings to be performed by approaching the device for measuring currents to the motor power supply cables at any point in their length from the origin thereof to the housing of the motor itself.

A further possible embodiment of the invention may be the method according to claims 30 to 36 wherein a device is used for measuring of currents according to claim 15 or any of its depending ones, for obtaining the signal relating to the stator currents in an electric motor.

**Brief Description of the drawings**

One embodiment of the invention will be described below by way of a nonlimiting example with reference to the enclosed drawings, in which:

Figure 1 shows a block diagram relating to one embodiment of the present invention;

Figure 2 shows a current collection probe according to one embodiment of the present invention;

Figure 3 shows a circuit diagram of one embodiment of the present invention;

Figure 4 shows discharges collected by a current collection probe according to one embodiment of the present invention;

Figure 5 shows a device for diagnosing of bearings according to one embodiment of the present invention;

Figures 6-9 show diagrams relating to discharges for each motor exceeding a specific threshold value at different speeds;

Figure 10 shows a block diagram according to the current measuring device according to one embodiment of the present invention;

Figure 11 shows a circuit diagram of the current measuring device according to one embodiment of the present invention;

Figure 12 shows a spectrum obtained by applying the current measuring device according to one embodiment of the present invention to a motor;

Figure 13 shows a second spectrum obtained by applying the current measuring device according to one embodiment of the present invention to a second motor;

Figure 14 is a diagrammatic view of an induction motor bearing, in which bearing parameters necessary to calculate the fault harmonics are shown;

Figure 15 shows the wavelet Agnesi function waveform;

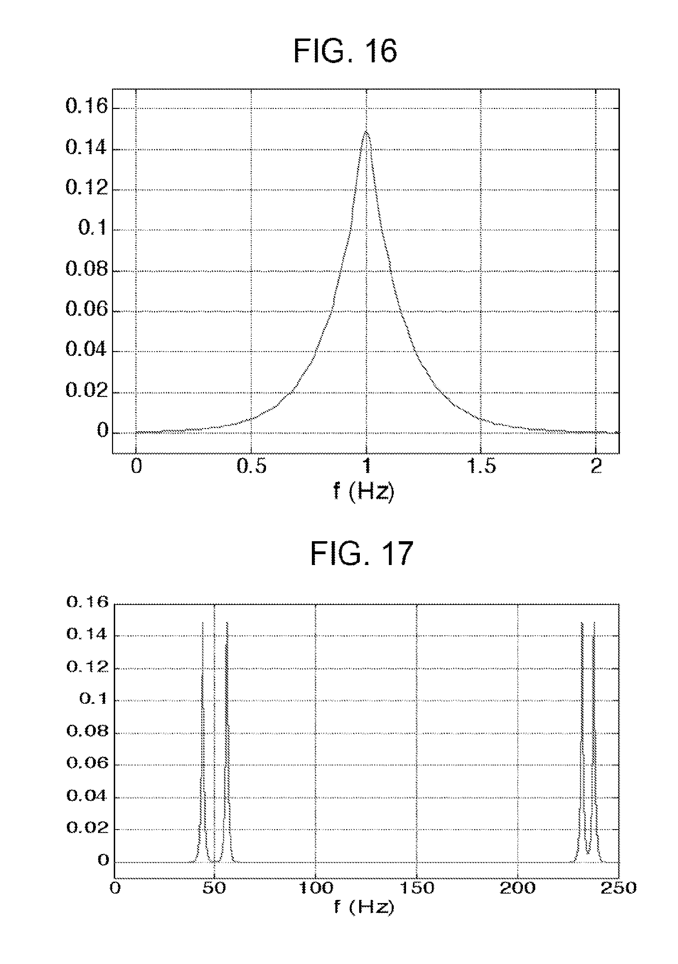

Figure 16 shows the frequency response of the wavelet Agnesi function;

Figure 17 shows one example of filter banks for the analysis of breakage in rotor bars or rings;

Figure 18 shows the result of the convolution of said filters with a motor having broken bars operated under non-stationary conditions of increasing torque;

Figure 19 shows the relationship between the actual rotational speed of the motor relative to the rated one and the level of power consumption relative to the rated one;

Figure 20 shows the spectrum of stator currents in an induction motor with broken bars and at a base frequency of 50 Hz;

Figure 21 shows a graph of the magnitude of the motor stator current in the trial.

## Description of a preferred embodiment

According to a first aspect, one embodiment of the invention comprises a device that allows reading of these common mode current signals, their suitability, their processing, and the visual indication of the diagnosis.

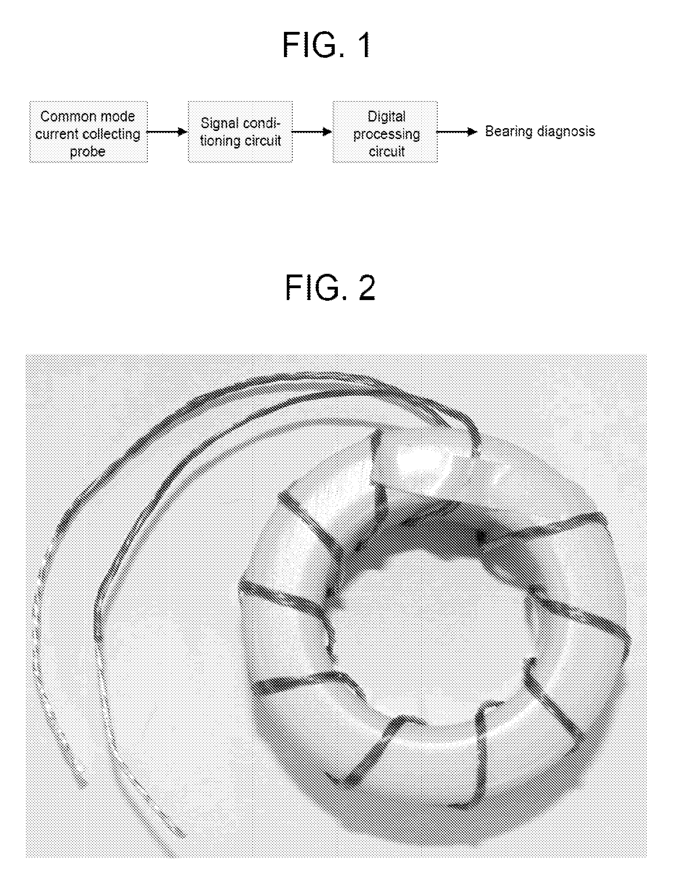

The steps for carrying out the method of the present embodiment are summarized in the three blocks as shown in Figure 1, which are: collecting of common mode current signal, transforming of the signal into a pulse if exceeding the set amplitude, and reading of the pulses by the system processor in a set time for displaying a diagnostic of the motors.

The design of the current discharge collecting probe is described below as well as the conditioning circuit for converting these pulses into square signals capable of being collected by a digital processor.

TABLE I Table of physical characteristics of the probe

| Inner radius (iR) | 9 mm | |
|---|---|---|
| Outer radius (oR) | 16 mm | |
| Height (h) | 10 mm | |
| Number of turns | 10 turns along the core | |
| Wire | Linz type | |
| Core material | Iron dust | |

### A. Collecting probe

The three wire corresponding to the phases pass together through the current sensor. It is important to remove the protective metal screen therefrom in case they are provided with.

The high frequency current probe with magnetic core has to be calibrated and validated.

Finally, the electrical and physical characteristics of the proposed probe are summarized in Table II.

TABLE II TABLE OF GENERAL CHARACTERISTICS OF THE PROBE

| Gain | 25 V/A (on a 50 Ω charge) |
|---|---|
| Bandwidth | 100 KHz - 10 MHz |
| Temperature range | -55˚ C - 125˚ C |
| Number of turns | 10 turns along the core |

### B. Conditioning circuit

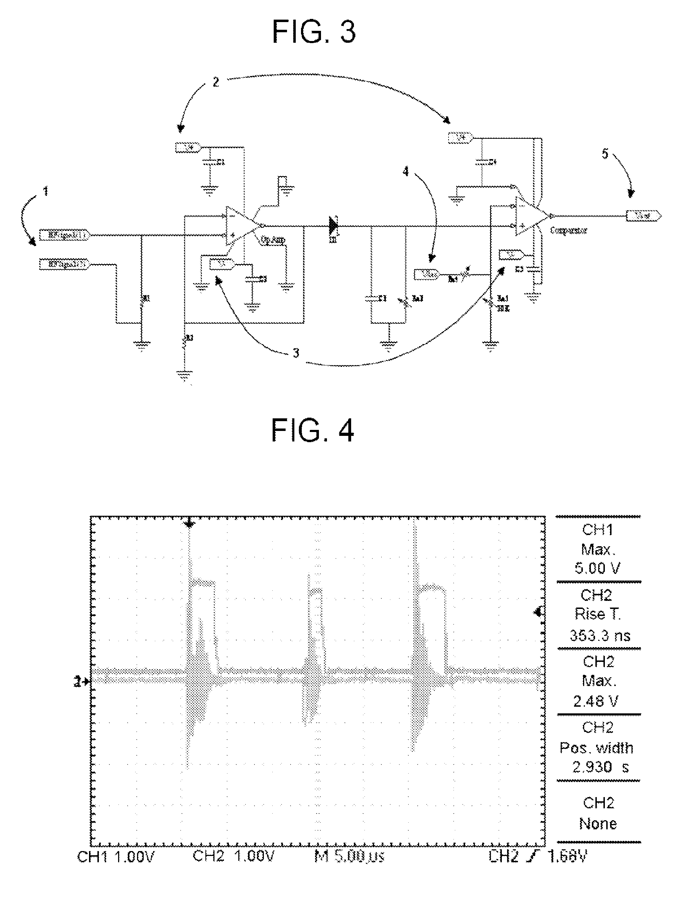

The proposed signal conditioning circuit, which would be located downstream the collecting probe, comprises two parts. The first one is a voltage adaptation and received signal pre-conditioning, Figure 3, the second one is based on a comparison between the first stage output and the reference analog voltage that may come from an external CPU or DSP which must be also the one that performs the counting during a set time of the pulses generated at this later stage to detect the state of the bearings. Thus, the circuit only has to receive the signal collected by the probe, the necessary power (+3.3 Vdc and GND in this design), and the voltage value corresponding to the threshold amplitude to be detected.

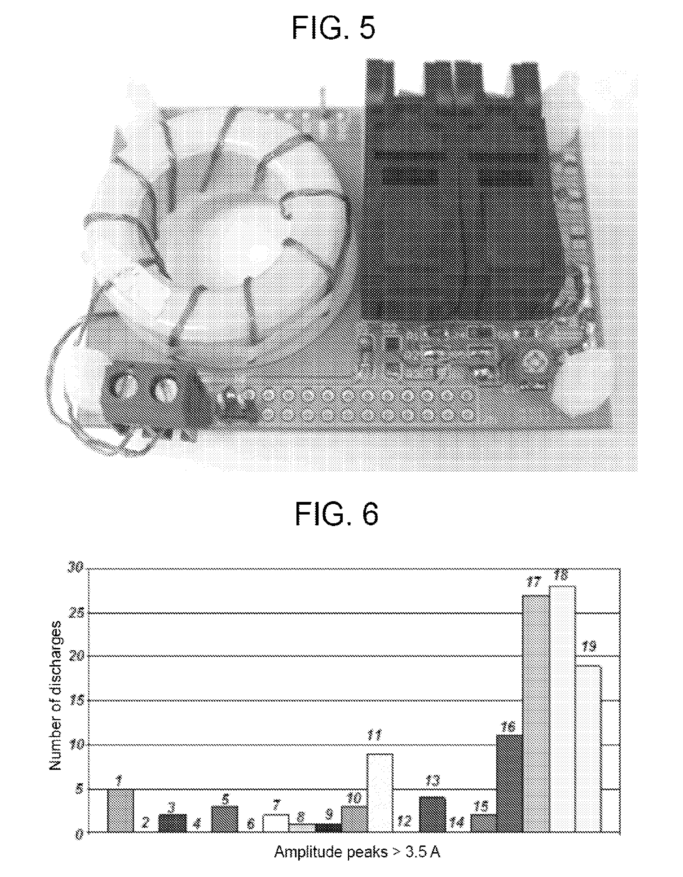

Finally, as shown in Figure 4, the discharges collected by the probe become transformed into pulses of fixed amplitude and a significant width for subsequent detection by digital equipment, Figure 5. Depending on the set voltage threshold in the comparing step of the electronic circuit, a greater or lesser number of pulses will be obtained which will diagnose the condition of the motor bearings.

The aim of the tests carried out on motors with the above described probe is to determine wear in bearings by analyzing common mode currents.

This analysis is performed through acquisitions of discharge currents through the probe that acquires and processes the signal placed at the output of the inverter that manages the motor. The object is to monitor the number of discharges exceeding a threshold. This information will be helpful for determining the condition of the bearings and the lubricant.

Eighteen 1.1 KW and thirteen 4KW induction motors were used for being tested, including healthy and damaged motors. The characteristics of these motors are shown in Tables III and IV respectively. The object is to determine the influence of bearing fault in common mode current discharges.

### C. Test method

1) Mounting the motor with no charge.
2) Mounting the corresponding inverter (different models suitable for 1.1 KW and 4 KW motors). Attaching of inverter mass to motor housing.
3) Measurements with the probe, by simultaneously measuring the three phases from the inverter to the motor.
4) Inverter configuration and startup by using the manufacturer's software.

The motors used, which were tested at three different speeds (15Hz, 25Hz and 50Hz), have the following characteristics:

TABLE III TABLE OF CHARACTERISTICS of 1.1 KW MOTORS

| Power | 1.1 | KW |
|---|---|---|
| Model | M2AA090S4 | - |
| Rated speed | 1410 | rpm |
| Rated I | 2.59 | A |
| Rated torque | 7.5 | Nm |
| Pair of poles | 2 | - |

TABLE IV TABLE OF CHARACTERISTICS of 4 KW MOTORS

| Power | 4 | KW |
|---|---|---|
| Model | M2AA0112M2 | - |
| Rated speed | 2895 | rpm |
| Rated I | 7.6 | A |
| Rated torque | 13.2 | Nm |
| Pair of poles | 1 | - |

### D. Obtained data and analysis

For each of the different speeds, 20 acquisitions of approximately 3.2 msec were collected to count the number of discharges occurred. Figures 6 to 9 show the number of discharges for each motor exceeding a specific threshold value at different speeds. The selection of the threshold corresponds to a criterion based on experience with motors in which, after analyzing the number of discharges exceeding threshold values in a range from 1.5 times to 0.5 times the rated current, that value providing a number of pulses allowing subsequent detection of bearing defect is chosen.

*1) 1. 1 KW motors.*

For motors with a rated power of 1.1 kW, the threshold that current discharge peaks must exceed is approximately 3.5 A, which is 1.3 times the rated current. Figure 6 shows the number of discharges higher than 3.5 A, for each motor at 15Hz. It can be seen that motors 17, 18 and 19 are healthy motors. In this way the threshold at 15 discharges could be determined so as to detect the healthy motor from the damaged one.

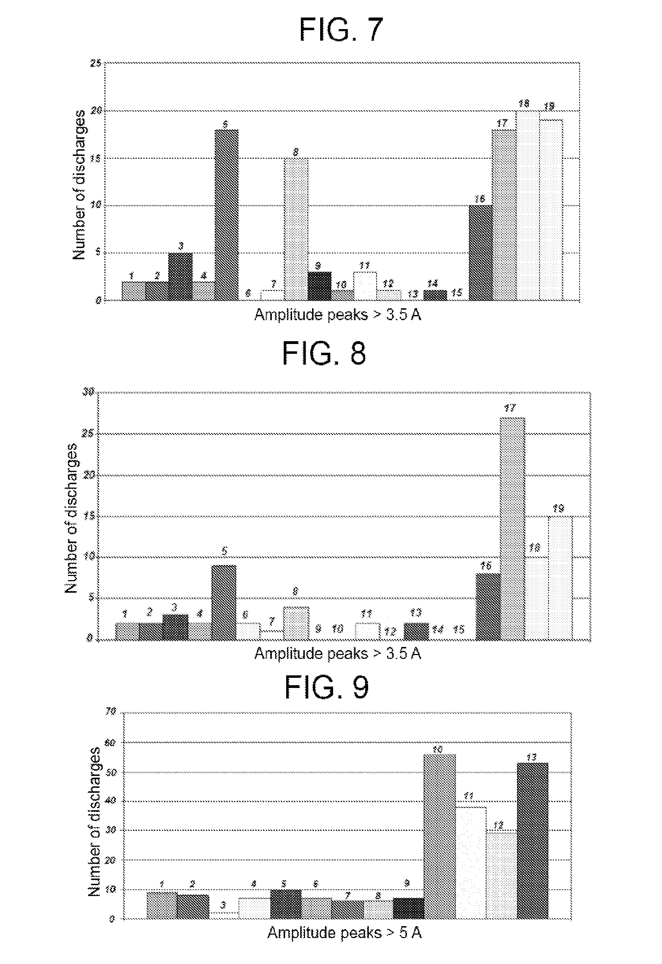

Figures 7 and 8 show the same information but at 25Hz and 50Hz respectively.

*2) 4 KVV Motors*

For 4 KW rated power motors, the amplitude of the current discharges should exceed a threshold of 5A, which corresponds to 0.6 times the rated current.

Figure 9 shows the number of discharges in excess of 5A for each motor at a set frequency of 15Hz. It can be seen that motors 10 to 13 are healthy motors, so the threshold of diagnosis could be set at 15 discharges.

According to a further preferred embodiment of the present invention there is provided a device for measuring currents comprising current collecting means through inductive methods of the Rogowski probe type.

The Rogowski probe gives a voltage value associated with changes in common mode currents that it collects when approached to a motor. Such common mode currents can be measured by approaching the probe to, for example, the housing or the shaft of the motor, but is much more comfortable, and the same result is obtained, when approaching the probe to the motor power supply cable.

Thus, the voltage given by the Rogowski probe is related to di/dt changes in the common mode current flowing through the motor, and it responds to the following equation:

$$V_o = \frac{\mu_0 n A}{2\pi r} \frac{di}{dt} = M \frac{di}{dt}$$

Due to this relationship, Rogowski probes are always used in combination with an integrator stage, which allows a signal directly proportional to the intensity to be obtained (in this case, proportional by parameter M), but the use of integrator stage introduces errors due to a possible saturation of the signal when passing through the integrator.

In the case of diagnosing of motors through the MCSA method, the result of the diagnosis is based on the spectral analysis of current in motor stator (i.e. common mode current of the motor), and, therefore, it is not necessary to obtain a signal directly proportional to the current in the motor: the derivative suffices. Therefore, the use of the integrative stage can be avoided, and therefore the problem of saturation that is introduced disappears, and as a result the adjustment problem also disappears, allowing the Rogowski probe to be used in series production.

The current flowing through the stator of a faulty alternating current electric motor can be modeled by the following expression.

$$x(t) = \sum_{i=0}^{\infty} \left( A_i sen\omega_i t \right)$$

Wherein $2\pi f_i$ corresponds to harmonic frequencies and $A_i$ to their amplitude.

The signal obtained through the Rogowski probe with no integrator is the derivative.

$$\frac{dx(t)}{dt} = \sum_{i=0}^{\infty} \left( \omega_i A_i \cos\omega_i t \right)$$

A signal is obtained with the same amount of harmonics and located at the same frequencies, only amplitude is varied by a previously known factor.

The obtained harmonics surprisingly exhibit greater amplitude as they are multiplied by their respective w, with this helping to their subsequent treatment since they are better discriminated among noise.

In summary, the advantages of using the proposed device are:

- Lower cost.
- No adjustment problems exist due to saturation of the integrator.
- Diagnosis is facilitated by the increased amplitude of the harmonics.

Since by performing the spectral analysis of the obtained signal the amplitude for each harmonic is multiplied by its respective frequency, harmonics have greater amplitude at a high frequency than in the case when an integrator stage is used. This results in a better use of the dynamic range of the AD (Analog-Digital) converter used for subsequent signal processing. This is especially useful for diagnosing motors by MCSA in case of low mechanical load on the motor shaft when harmonic amplitudes above the fundamental are very small. By using the present device with Rogowski probe with no integrator, the amplitude of these harmonics is multiplied by its respective frequency and they are more easily detectable.

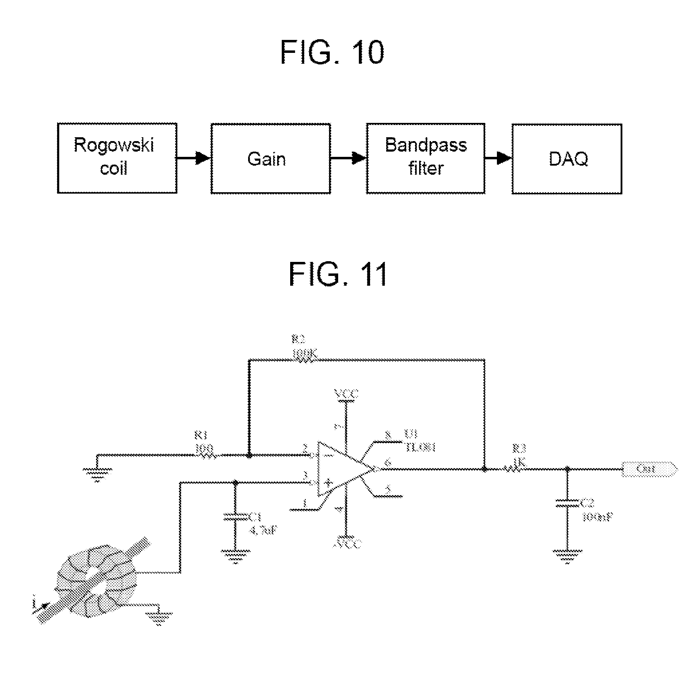

More specifically, one example of Rogowski probe whose size is optimal for the standard current collection may be one with an amplifier step having a RC filter with a cut-off frequency of 1.5 kHz, and resistance values of 1 k Ohm and capacitance of 100nF, as shown in Figure 11.

For the purpose of diagnosing 90 sized motors according to the present embodiment of the invention, a Rogowski coil has been designed on a polyethylene core with n = 500, A = 56.25 mm$^2$, and r = 3.75 mm. With these values, the mutual inductance is M = 500 nH.

The machine measuring and diagnosis equipment comprises a Rogowski coil without the integrator circuit (Figure 10).

Analog electronics is detailed in Figure 11 and it comprises a signal amplifier stage equal to 1 k, in a non-inverting amplifier configuration, and a second filter stage, forming an RC filter to prevent aliasing effect at a cut-off frequency of 1.5 kHz, with resistor values of 1 k Ohm and capacitance of 100nF.

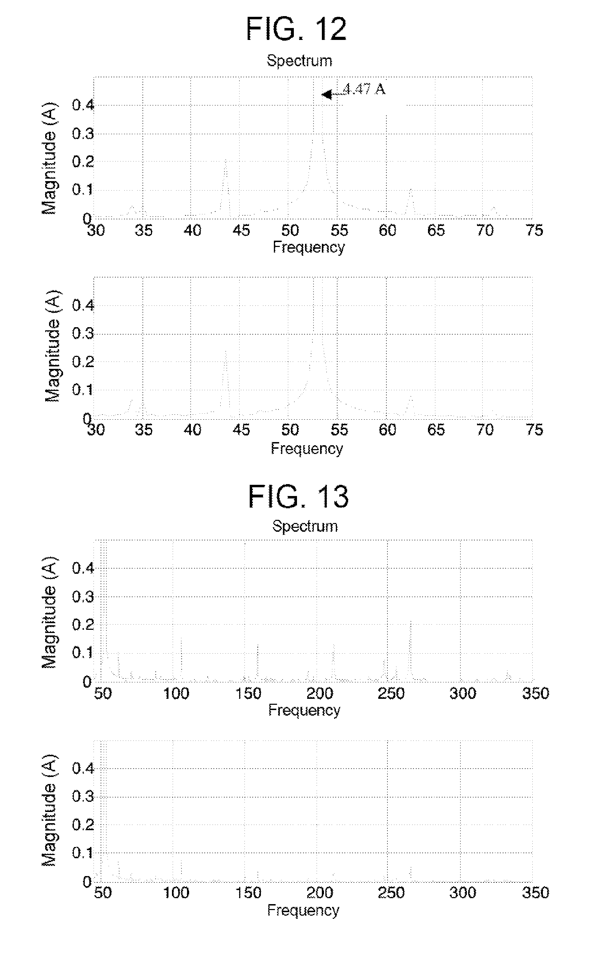

Figure 12 shows the spectrum obtained from a motor having 8 broken bars and operated at 53 Hz, the upper spectrum shows the measurement with a Rogowski probe with no integrator, the lower one with integrator.

Figure 13 shows the same information as in Figure 12 but at a frequency range up to 350 Hz

Figures 12 and 13 show the effectiveness of the proposed measuring equipment.

According to a further aspect of the invention, another preferred embodiment relates to a method for detecting defects in alternating current electric motors comprising the steps of:

a) Obtaining the signal relating to electric motor stator currents;
b) Obtaining speed and sliding evolution of the electric motor from the signal relating to the obtained stator currents;
c) Locating a plurality of fault frequencies of the obtained signal relating to a motor fault;
d) Calculating a filter bank relating to the located fault frequency through the wavelet Agnesi function;
e) Convoluting the signal obtained with the filter banks;
g) Obtaining a fault factor by the integral of the squared convolution result Referring to step b), that is, for determining speed and sliding, which are key parameters for correct positioning of the various filters and therefore for optimizing the diagnosis, the following method will be preferably used from the motor stator currents:

i) Through zero crossing of the stator current and as the inverse to time when passing through zero, the main power frequency ($f_s$) is provided twice

$$f_s = \frac{1}{2 \cdot t}$$

as the zero crossing corresponds to a half wave.

ii) From the main frequency of the stator current ($f_s$), and the parameters of construction (pairs of poles) of the motor being known, the synchronous speed ($n_s$) is obtained through the following formula:

$$n_S = \frac{60 \cdot f}{p}$$

iii) Sliding (s) is obtained from the synchronous speed through the following equation:

$$s = \frac{n_S - n}{n_S}$$

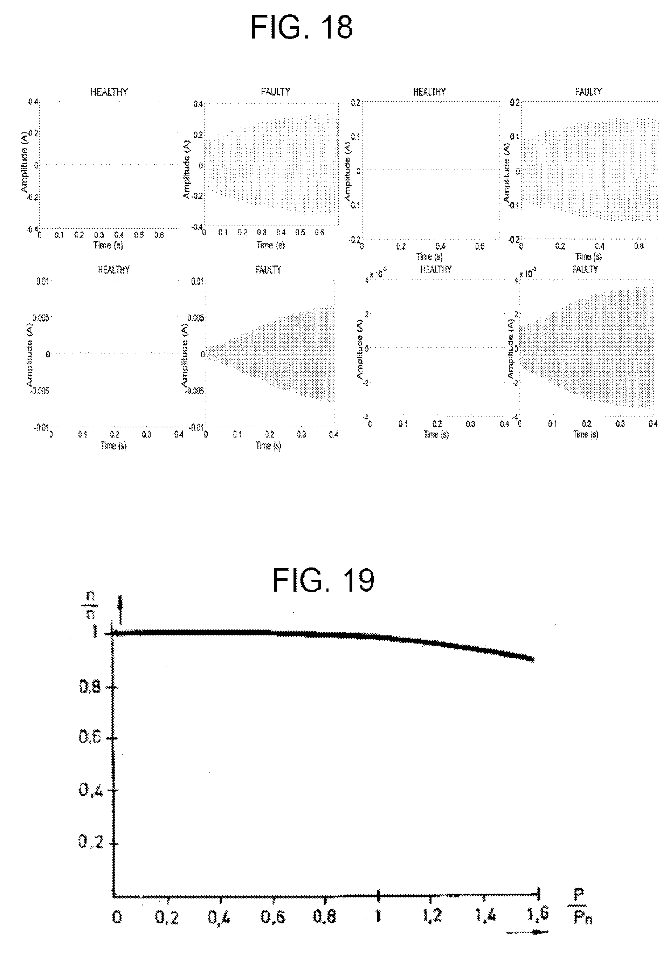

iv) In order to have the sliding value it is essential to know the speed of rotation, which is a function of the power consumed by the motor and which is shown in Figure 19.

v) Calculation of the power consumed will be carried out from motor currents, with the power (P) being:

$$P = U \cdot I$$

Referring to step "d", the method of calculating different filter banks to be tuned for each different value of the fault frequency over time is detailed below.

The three phases of the supply intensity ($i_R$, $i_S$, $i_T$) of the motor will have the following mathematical decomposition, with '$f_n$' being the frequency of the harmonics corresponding to each of the defects present in the electric motor:

$$i_R(t) = \sqrt{2}\, I_R \cos 2\pi f_s t + \sqrt{2} \sum_{n=0}^{N} I_{Rn} \cos\left(2\pi f_n t - \varphi_{Rn}\right)$$

$$i_S(t) = \sqrt{2}\, I_S \cos\left(2\pi f_s t - \frac{2\pi}{3}\right) + \sqrt{2} \sum_{n=0}^{N} I_{Sn} \cos\left(2\pi f_n t - \varphi_{Sn} - \frac{2\pi}{3}\right)$$

$$i_T(t) = \sqrt{2}\, I_T \cos\left(2\pi f_s t - \frac{4\pi}{3}\right) + \sqrt{2} \sum_{n=0}^{N} I_{Tn} \cos\left(2\pi f_n t - \varphi_{Tn} - \frac{4\pi}{3}\right)$$

wherein $I_R = I_S = I_T = I$ are the RMS values of the fundamental component of phase current, $I_{Rn}$, $I_{Sn}$, $I_{Tn}$ are the RMS values of the fault components; and $\varphi_{Rn}$, $\varphi_{Sn}$, $\varphi_{Tn}$ are the phase difference for each of these components.

In view of the above mathematical decomposition of the currents, a method of diagnosis could be the observation of the value of the intensity or of the energy associated with each of the characteristic fault frequencies. However, in order to accomplish this task and ensuring that no problems arise due to the analysis during stationary operation conditions the present embodiment makes use of the convolution of the wavelet Agnesi function of the sample of supply current motor stator measured by different filter banks.

Wavelet Agnesi function, which is based on the Agnesi function, has two properties: it has a finite length in time domain and its mean value is zero, whereby each wavelet function could be considered as a filter in the frequency domain. This allows easily tunable filter banks to be defined, making possible a temporal study of the different characteristic fault frequencies. The wavelet function is as follows:

$$\varphi(t) = C\cos(2\pi \cdot f_c \cdot t) \cdot \frac{2}{1 + \left(\frac{t}{f_b}\right)^2}$$

As shown in Figure 2, the wavelet Agnesi function has a waveform, and a frequency response corresponding to a bandpass filter shown in Figure 3, which can be easily tuned through the variation of 'f$_c$' (which corresponds to its center frequency). Its bandwidth is controlled through the parameter 'f$_b$'. The constant C is a normalization constant of the function, which allows the desired gain to be adjusted.

In order to improve the effectiveness of detection of defects different convolution filters are implemented such that the filter bank set applied for each type of defect will have the following mathematical notation:

$$\varphi(t) = \begin{bmatrix} \cos(2\pi \cdot f_1 \cdot t) \cdot \dfrac{2}{1 + \left(\frac{t}{f_b}\right)^2} + \cos(2\pi \cdot f_2 \cdot t) \cdot \dfrac{2}{1 + \left(\frac{t}{f_b}\right)^2} + \\ \cos(2\pi \cdot f_3 \cdot t) \cdot \dfrac{2}{1 + \left(\frac{t}{f_b}\right)^2} + \ldots + \cos(2\pi \cdot f_n \cdot t) \cdot \dfrac{2}{1 + \left(\frac{t}{f_b}\right)^2} \end{bmatrix}$$

wherein the value of each frequency $f_1$, $f_2$, $f_3$ ... $f_n$ corresponds to the characteristic frequencies of each defect.

Referring to the above mentioned step e) relating to the step of convoluting the obtained signal, it will be carried out by convolving the supply current vector with the different filter banks corresponding to each fault condition.

Subsequently, in step f), the energy associated with these harmonics will be assessed by integrating the squared resulting vector, thus obtaining the fault factor (F).

Convolution + integration operations of the squared vector, corresponding to steps f) and g) can be performed in one or more steps at a time, yielding identical results.

In order to successfully perform fault diagnosis in alternating current electric motors the value of these harmonics should be assessed depending on the type of error:

**a) Eccentricities:**

$$f_{ecc} = f_s\left[1 \pm m\left(\frac{1-s}{p}\right)\right]$$

wherein 'f$_s$' corresponds to the frequency of the supply current, 'm' = 1,2,3 ... is a harmonic number, 's' corresponds to machine sliding, and 'p' to the number of pairs of poles.

**b) Breakage of rotor bars and rings:**

$$f_{bdb} = f_s \left[ l \left( \frac{1-s}{p} \right) \pm s \right]$$

wherein the condition that the relationship with 'p' should be 'l/p' = 1,2,3 ... must be met by l

**c) Breakage of Bearings:**

$$f_{bng} = \left| f_s \pm m f_{i,o} \right| \qquad f_{i,o} = \frac{n_b}{2} f_r \left[ 1 \pm \frac{bd}{pd} \cos \beta \right]$$

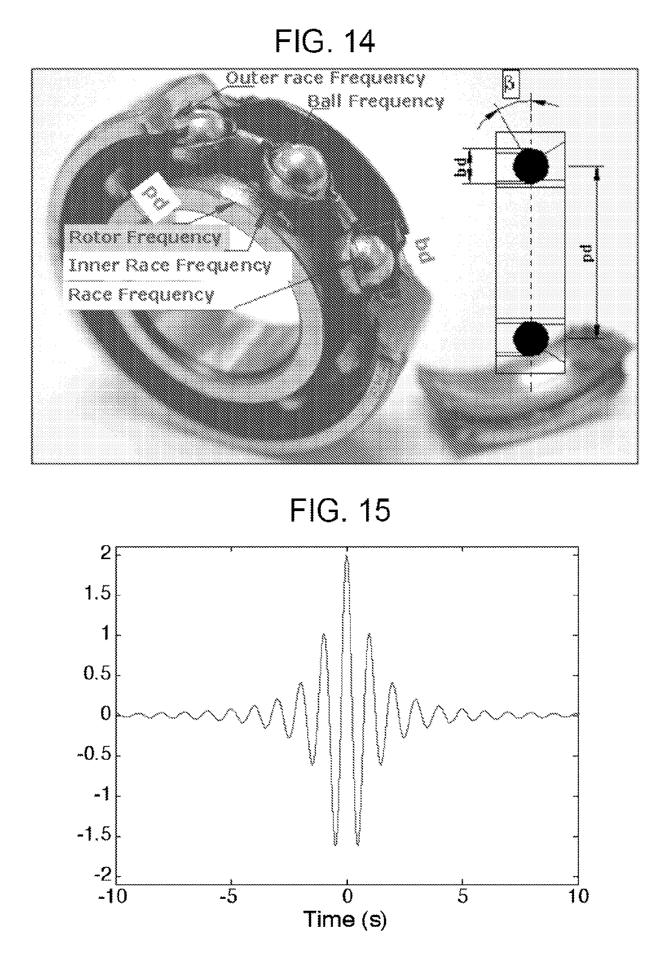

wherein '$n_b$' is the number of bearing balls, '$f_r$' is the frequency of rotation of the rotor, 'bd' is the diameter of the bearing ball, 'pd' is the diameter of the bearing race and finally 'ß' corresponds to the angle of attack of the ball on the race, as shown in Figure 14.

**d) Short-circuits:**

Medium frequencies

$$f_{stb} = f_s \left[ 1 \pm m Z_2 \left( \frac{1-s}{p} \right) \right]$$

Low frequencies

$$f_{stl} = f_s \left[ \frac{m}{p} (1-s) \pm k \right]$$

wherein k = 1,2,3 ... and '$Z_2$' is the number of slots or bars provided in the rotor.

Although diagnosing from the assessment of a single fault harmonic could be possible, in order to ensure the maximum accuracy the diagnosis system of the invention will employ a set of four characteristic harmonics to ensure proper diagnosis.

The method for detecting defects in alternating current electric motors of the invention will be preferably used for asynchronous motors (also referred to as induction motors) when it is desired to diagnose both on-line and off-line defects, that is either during normal operation of the motor or when disconnected.

However, the method of the invention will be also used with optimum results for permanent magnet synchronous motors when it is desired to perform on-line diagnosing of defects, that is during normal motor operation.

This method can be also applicable to the analysis of vibrations or acoustic emission, according to the characteristic frequencies at every time.

The present embodiment of the method for diagnosing defects of the invention has many advantages over other alternative methods used so far for on-line diagnosing defects in alternating current electric motors, which are summarized below:

-   It allows the diagnosis to be performed automatically and in real time.

- It magnifies fault condition, small variations in the amplitude can be detected through the use of the constant 'C'.
- It is independent on the operating conditions (steady or transient state).
- It is independent on rotational speed or supply frequency of the motor.

Secondly, there is provided an equipment for carrying out the above described method for diagnosing defects in alternating current electric motors. The equipment comprises means for measuring motor stator currents, means for calculating the speed and sliding evolution of the motor, means for calculating the different filter banks corresponding to each fault condition, and means for calculating the different fault factors.

Preferably said means for measuring the motor stator currents will be a probe connected to the electric motor, which enables a range of acquisition from 2 to 5 kHz.

The means for calculating the different fault factors will perform convolution of the supply current vector with the different filter banks corresponding to each fault condition and the subsequent integral of the squared resulting vector.

Results of a trial conducted with the aim of verifying the results obtained by the application of a wavelet and power spectral density analysis are set forth and shown below.

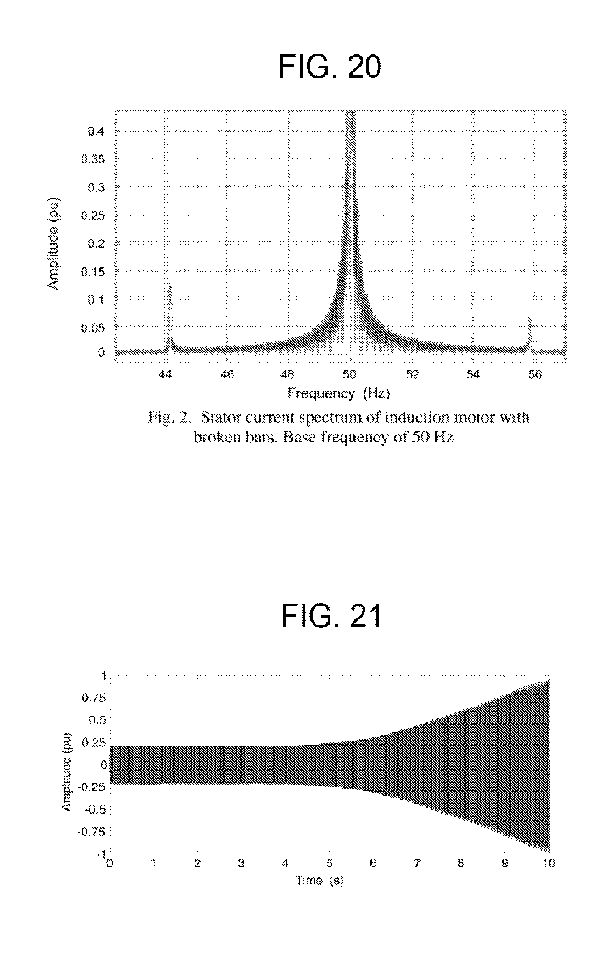

The trial is based on the analysis of a motor under constant and varying load torque. The motor used has a faulty rotor with four broken rotor bars, and in which harmonic caused by such defect has an amplitude of 15% of the rated current, see Figure 20. To perform the trial it has been selected a sample frequency $f_s$= 6000 Hz, a number of samples of N = 65536, and results in a frequency bandwidth of 3000 Hz and a resolution of 92 mHz on a Fast Fourier Transform (FFT) analysis, which is sufficient to cover the significant band of the motor (0-400 Hz) and to be able of distinguishing the harmonics due to the defect and the harmonics due to supply inverter.

The specifications for the type of induction motor are enclosed below in table 1.

Table 1

| Induction motor | Value |
| --- | --- |
| Rated power | 1.1 kW. Star: 380V/2.6 A |
| Number of poles | 4 |
| Nominal speed | 1410 rev/min |
| Cos φ | 0.81 |

The motor is supplied with a sinusoidal voltage at a main frequency of 50 Hz, and works with four broken rotor bars. Figure 21 shows the variation of current over time and the increase of the load is clear at t = 5s.

The results obtained from several tests under varying load torques are shown in Figure 18.

Since error varies with load variation, the fault frequencies vary on the spectrum.

Although the harmonic frequency is continually varying during the application of variable torque, the instantaneous peak to the peak value of the detail almost covers the instantaneous harmonic amplitude due to the fault. This is clear by comparing the harmonic of fault in Figure 20 (constant torque) and the evolution of the harmonic amplitude in Figure 18 (varying torque).

Finally, Table 2 clearly shows the increase in energy by a fault condition in the approach and the detailed decomposition at level 7. This energy is calculated by addition of the boxed coefficients.

Table 2

| | Faulty BRB | Healthy |
| --- | --- | --- |
| f1 | 0.34 | 0.0002 |
| f2 | 0.22 | 0.0002 |
| f3 | 0.085 | 4.32 e$^{-6}$ |
| f4 | 0.0043 | 1.25 e$^{-6}$ |

Table 2 clearly illustrates the increased energy of the selected convolution. Therefore, the two coefficients of the wavelet decomposition shown in said Table 3 may be used for detecting defects in motors, since the fault condition clearly differs on the wavelet coefficient boxes and the increase is over 100 times in the case of faulty motors.

The findings of the disclosed trial are the following:

- wavelet convolution is a suitable technique for the isolation time components of non-stationary signals;
- energy of some wavelet convolution is easy to computerize, thereby obtaining good results for the assessment of frequency signals, and
- wavelet convolution energy can be used for detecting defects in the rotor of a varying load torque electric motor.

Although specific embodiments of the present invention have been described and shown, it is clear that those skilled in the art will be able to introduce variants and modifications, or to replace the details with others that are technically equivalent, without departing from the scope of protection defined by the appended claims.

## Claims

1. Device for diagnosing bearings in three-phase motors comprising at least one inductive effect probe for the acquisition of common mode currents and current processing means, comprising counting means for the number of discharges per unit time.

2. Device as claimed in claim 1, wherein the inductive effect probe comprises a ferromagnetic core.

3. Device as claimed in claim 1, wherein the inductive effect probe is a probe of the Rogowski type.

4. Device as claimed in any of the claims 1 to 3, wherein the current processing means comprise a current discharge counting circuit comprising at least one analog stage.

5. Device as claimed in claim 4, wherein the discharge counting circuit is a common mode current discharge counting circuit.

6. Device as claimed in claim 4 or 5, wherein the analog stage comprises a signal preconditioning step and a comparing step.

7. Device as claimed in claim 6, wherein the comparing step comprises at least one analog comparator.

8. Device as claimed in any of the claims 1 to 7, wherein the current processing means comprise a discharge counting circuit comprising a digital stage.

9. Device as claimed in claim 8, wherein the digital stage comprises a PLD for the counting of pulses.

10. Device as claimed in claims 8 or 9, wherein the digital stage is comprised within a microcontroller.

11. Device as claimed in claim 8 or 9, wherein the digital stage is comprised within a DSP.

12. Device as claimed in claim 10, wherein the microcontroller is embedded within a FPGA.

13. Method for diagnosing bearings in three phase motors comprising the steps of:

    - Obtaining a signal relating to the common mode current of the motor;
    - Counting the number of peaks exceeding a predetermined value of current for a predetermined period of time.

14. Method as claimed in claim 13, wherein in the step of carrying out counting, the predetermined value of current is in the range of 0.5 to 1.5 times the rated current of the obtained signal.

15. Device for measuring currents comprising current collection means by inductive methods and conditioning electronics comprising at least one amplifier stage and at least one filter stage, said device lacking an integrator circuit.

16. Device as claimed in claim 15, wherein the current collection means are a Rogowski probe.

17. Device as claimed in claim 15, wherein the current collection means are a probe with ferromagnetic core.

18. Device as claimed in any of claims 15-17, wherein the amplifier stage comprises a non-inverting stage and a low-pass RC filter.

19. Device as claimed in any of claims 15-18, wherein it is for use in diagnosing of electrical equipment.

20. Device as claimed in any of claims 15-18, wherein it is for use in diagnosing of electric machines.

21. Device as claimed in claim 20, wherein the electric machines are alternating current machines.

22. Device as claimed in claim 21, wherein the alternating current electric machines are induction motors.

23. Device as claimed in claim 21, wherein the alternating current machine is a PMSM motor.

24. Device as claimed in claim 21, wherein the alternating current machine is a SRM motor.

25. Use of a device for measuring currents as claimed in any of claims 15-24 for the prognosis of electric machines.

26. Use of a device for measuring currents as claimed in claim 25, wherein the electric machine is an alternating current machine.

27. Use of a device for measuring currents as claimed in claim 26, wherein the alternating current electric machine is an induction motor.

28. Use of a device for measuring currents as claimed in claim 26, wherein the alternating current electric machine is a PMSM motor.

29. Use of a device for measuring currents as claimed in claim 26, wherein the alternating current electric machine is a SRM motor.

30. Method for detecting defects in electric motors for diagnosing defects in motor operation by non-invasive methods, comprising the application of self-tuning filters based on the convolution of the wavelet Agnesi function with the supply currents of the electric motor.

31. Method for detecting defects in alternating current electric motors as claimed in claim 30, comprising the steps of:

    a) Obtaining the signal relating to stator currents of an electric motor;
    b) Obtaining the speed and sliding evolution of the electric motor;
    c) Locating at least one fault frequency of the signal obtained;
    d) Calculating at least one filter relating to the located fault frequency, by using the wavelet Agnesi function;
    e) Convoluting the signal obtained with the calculated filter;
    f) Obtaining a fault factor by the integral of the squared convolution result.

32. Method for detecting defects as claimed in claim 31, wherein the step b) of obtaining the speed and sliding evolution is performed using the stator currents themselves.

33. Device for detecting defects in alternating current motors, **characterized in that** it comprises means for obtaining the signal relating to currents in the stator of an electric motor, means for obtaining the speed and sliding evolution of the electric motor; means for locating at least one fault frequency of the obtained signal; means for calculating at least one filter relating to the located fault frequency, by using the wavelet Agnesi function; means for convolving the signal obtained with tuned filter banks, and means for obtaining a fault factor by the integral of the squared convolution result.

34. Device for detecting defects in alternating current motors as claimed in claim 33, wherein the means for obtaining the signal relating to currents in the stator of an electric motor is a probe with a range of acquisition from two to 5 kHz.

35. Use of the device for detecting defects as claimed in any of claims 33 to 34, wherein the electric motor is a permanent magnet synchronous motor.

36. Use of the device for detecting defects as claimed in any of claims 33 to 34, wherein the electric motor is an

asynchronous motor.

# FIG. 1

```
┌──────────────────┐    ┌──────────────┐    ┌──────────────┐
│  Common mode     │    │ Signal condi-│    │   Digital    │
│ current collecting│──▶│ tioning circuit│──▶│  processing  │──▶ Bearing diagnosis
│     probe        │    │              │    │   circuit    │
└──────────────────┘    └──────────────┘    └──────────────┘
```

# FIG. 2

# FIG. 3

# FIG. 4

| | |
|---|---|
| CH1 Max. 5.00 V | |
| CH2 Rise T. 353.3 ns | |
| CH2 Max. 2.48 V | |
| CH2 Pos. width 2.930 s | |
| CH2 None | |

CH1 1.00V    CH2 1.00V    M 5.00 µs    CH2 ∫ 1.68V

# FIG. 5

# FIG. 6

Amplitude peaks > 3.5 A

## FIG. 7

Amplitude peaks > 3.5 A

## FIG. 8

Amplitude peaks > 3.5 A

## FIG. 9

Amplitude peaks > 5 A

# FIG. 10

```
┌──────────┐      ┌──────────┐      ┌──────────┐      ┌──────────┐
│ Rogowski │  →   │   Gain   │  →   │ Bandpass │  →   │   DAQ    │
│   coil   │      │          │      │  filter  │      │          │
└──────────┘      └──────────┘      └──────────┘      └──────────┘
```

# FIG. 11

# FIG. 12

Spectrum

# FIG. 13

Spectrum

## FIG. 14

## FIG. 15

## FIG. 16

## FIG. 17

# FIG. 18

# FIG. 19

# FIG. 20

Fig. 2. Stator current spectrum of induction motor with
broken bars. Base frequency of 50 Hz

# FIG. 21

**INTERNATIONAL SEARCH REPORT**

| | |
|---|---|
| International application No. | |
| PCT/ ES 2008/000719 | |

A. CLASSIFICATION OF SUBJECT MATTER

see extra sheet

According to International Patent Classification (IPC) or to both national classification and IPC

B. FIELDS SEARCHED

Minimum documentation searched (classification system followed by classification symbols)
G01M, G01R, H02K5, H02K11

Documentation searched other than minimum documentation to the extent that such documents are included in the fields searched

Electronic data base consulted during the international search (name of data base and, where practicable, search terms used)

INVENES,EPODOC, WPI, XPI3E, NPL

C. DOCUMENTS CONSIDERED TO BE RELEVANT

| Category* | Citation of document, with indication, where appropriate, of the relevant passages | Relevant to claim No. |
|---|---|---|
| A | David Dah; Dominic Sosnowski; David Schlegel; Russ J Kerkman; Mike Pennings. "GEAR UP YOUR BEARINGS" IEEE INDUSTRY APPLICATIONS MAGAZINE. 01.07.2008. ISSN 1077-2618 | 1-14 |
| A | DE 4441828 A1 (BITTNER HELMAR) 29.06.1995 Abstract. | 1-4 |
| X | US2007236208 A1 (KOJOVIC ET AL) 11.10.2007 Paragraphs [0062][0080][0083] | 15-29 |
| X | US 6414475 B1 (DAMES ET AL.) 02.07.2002 column 3, line 24-58 | 15 |
| X | EP 1077380 A2 (SIEMENS AKTIENGESELLSCHAFT) 21.02.2001. Paragraphs [0002]-[0007] | 15-29 |

☒ Further documents are listed in the continuation of Box C.    ☒ See patent family annex.

| | | |
|---|---|---|
| * | Special categories of cited documents: | |
| "A" | document defining the general state of the art which is not considered to be of particular relevance. | |
| "E" | earlier document but published on or after the international filing date | |
| "L" | document which may throw doubts on priority claim(s) or which is cited to establish the publication date of another citation or other special reason (as specified) | |
| "O" | document referring to an oral disclosure use, exhibition, or other means | |
| "P" | document published prior to the international filing date but later than the priority date claimed | |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other documents , such combination being obvious to a person skilled in the art

"&" document member of the same patent family

| Date of the actual completion of the international search | Date of mailing of the international search report |
|---|---|
| 13.April.2009      (13.04.2009) | **(15/04/2009)** |
| Name and mailing address of the ISA/ O.E.P.M.  Paseo de la Castellana, 75 28071 Madrid, España. Facsimile No.   34 91 3495304 | Authorized officer  L. García Aparicio  Telephone No. +34 91 349 30 57 |

Form PCT/ISA/210 (second sheet) (July 2008)

**INTERNATIONAL SEARCH REPORT**

| International application No. |
| --- |
| PCT/ES 2008/000719 |

| C (continuation). | DOCUMENTS CONSIDERED TO BE  RELEVANT |

| Category* | Citation of documents, with indication, where appropriate, of the relevant passages | Relevant to claim No. |
| --- | --- | --- |
| X | Cusido J; Rosero J A; Cusido M; Garcia A; Ortega J A; Romeral L; Author Q "On-Line System for Fault Detection in Induction Machines based on Wavelet Convolution" Power Electronics Specialists Conference, 2007. PESC 2007. IEEE, PD-2007-06-17,PG- 927 - 932. ISBN 978-1-4244-0654-8 ; ISBN 1-4244-0654-4. | 30-36 |
| X | Cusido J; Rosero J A; Cusido M; Garcia A; Ortega J A; Romeral L "On-Line System for Fault Detection in Induction Machines Based on Wavelet Convolution". Instrumentation and Measurement Technology Conference Proceedings, 200 7 IEEE. PD-2007-05-01. PG 1 - 5. ISBN 978-1-4244-0588-6 ; ISBN 1-4244-0588-2 | 30-36 |
| A | Rosero J; Cusido J; Ortega J A; Romeral L; Garcia A. PMSM Bearing Fault Detection by means of Fourier and Wavelet transform. Industrial Electronics Society, 2007. IECON 2007. 33rd Annual Conference of the IEEE, PD 2007-11-05. PG1163 - 1168. ISBN 978-1-4244-0783-5 ; ISBN 1-4244-0783-4. | 30 |
| A | WO 02089305 A1 (SQUARE D COMPANY) 07.11.2002 pages 1 and 2 | 30 |

Form PCT/ISA/210 (continuation of second sheet) (July 2008)

## INTERNATIONAL SEARCH REPORT

Information on patent family members

| International application No. |
|---|
| PCT/ ES 2008/000719 |

| Patent document cited in the search report | Publication date | Patent family member(s) | Publication date |
|---|---|---|---|
| DE 4441828 A | 29.06.1995 | NONE | ------------ |
| US 2007236208 A | 11.10.2007 | NONE | ------------ |
| US 6414475 B | 02.07.2002 | GB 2353099 AB | 14.02.2001 |
| | | WO 0111376 A | 15.02.2001 |
| | | CA 2380934 AC | 15.02.2001 |
| | | AU 6008400 A | 05.03.2001 |
| | | BR 0013073 A | 30.04.2002 |
| | | EP 1206705 AB | 22.05.2002 |
| | | EP 20000946213 | 24.07.2000 |
| | | CN 1379860 A | 13.11.2002 |
| | | CN 1161619 C | 11.08.2004 |
| | | AT 259070 T | 15.02.2004 |
| | | MXPA 02001161 A | 21.05.2004 |
| | | PT 1206705 T | 30.06.2004 |
| | | DE 60008119 T | 09.09.2004 |
| | | ES 2219362 T | 01.12.2004 |
| EP 1077380 A | 21.02.2001 | EP 20000117665 | 16.08.2000 |
| | | DE 19939222 A | 29.03.2001 |
| XP 031218408 A | 17.06.2007 | NONE | ------------ |
| XP 031182235 A | 00-05-2007 | NONE | ------------ |
| XP 031235068 A | 05.11.2007 | NONE | ------------ |
| WO 02089305 A | 07.11.2002 | US 2002186039 A | 12.12.2002 |
| | | US 6727725 B | 27.04.2004 |
| | | EP 1421670 A | 26.05.2004 |
| | | EP 20020729075 | 30.04.2002 |

**INTERNATIONAL SEARCH REPORT**

International application No.

PCT/ ES 2008/000719

CLASSIFICATION OF SUBJECT MATTER

*G01M 13/04* (2006.01)
*G01R 15/18* (2006.01)
*G01M 15/00* (2006.01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001289738 B